# EUROPEAN PATENT APPLICATION

(11) **EP 1 006 568 A1**
(43) Date of publication of application: **07.06.2000**
(21) Application number: 98830722.9
(22) Date of filing: 02.12.1998
(51) Int. Cl.: H01L 21/311, H01L 21/3213

(54) **Enhancing protection of dielectrics from plasma induced damages**

(71) Applicant: STMicroelectronics S.r.l., 20041 Agrate Brianza (Milano) (IT)
(72) Inventor: Pio, Federico, 20047 Brugherio (IT)
(74) Representative: Pellegri, Alberto

(57) **Abstract**

During critical plasma etching steps, the wafer's surface is illuminated with electromagnetic radiation in the visible and/or in UV spectrum of energy and power density sufficient to enhance the reverse current through protective junctions that are commonly realized for providing electrical discharge paths for electrical charges picked up by exposed conductive parts to limit the level of induced voltages to values compatible with the preservation of the integrity of functional dielectric layers coupled to the exposed conductors parts and to the semiconductor substrate or to another conductive part.

## Description

### FIELD OF THE INVENTION

The present invention relates to fabrication techniques of semiconductor devices and more in particular to the prevention of damages to functional dielectrics caused by voltages induced when processing a wafer in plasma.

### BACKGROUND OF THE INVENTION

In modern fabrication processes of semiconductor devices according to a VLSI or ULSI technology and the like, one of the most important reliability problem is to preserve the integrity of the dielectric characteristic of thin oxide layers (gate oxide, interpoly dielectric, etc.) during the conditions of treatment of the wafers. The criticity of this requisite is ever more important because of the technological advances that imply a continuous reduction (scaling down) of the thickness of functional dielectric films (for example nowadays gate oxide thickness in the order of 5nm or even less are commonly used).

Many process steps may potentially degrade or damage the dielectric characteristic of such functionally "active" oxides. However it is well known that among the most dangerous conditions under this profile are those that occur during dry etching in plasma to pattern the first levels of metallization, or at the beginning of the exposure of the wafer to a plasma, as for example for deposing isolation layers be the so-called PECVD (Plasma Enhanced Chemical Vapor Deposition).

Structural features of electrically conducting material on the surface of the wafer that are so directly exposed to the plasma, customarily placed on a plate electrode or briefly "platen" of the reactor that cooperates with a counterelectrode in provoking the ionization of a gaseous mixture introduced in the evacuated chamber by injecting radio frequency (RF), act as antennas and charge electrically.

The electric path may include the electric charge of an "active" dielectric film such as a gate oxide or an interpoly dielectric, and the strong electric field that is induced on the dielectric may damage it due to a breakdown toward the wafer substrate and the electrode on which the wafer is placed.

The effects of such breakdown currents through thin gate or interpoly isolation dielectrics may irreversibly degrade the dielectric properties. In order to limit below an empirically determined value the electric stress that may be induced in the dielectric, appropriate design expedients are currently implemented.

These practices are essentially based on checking the RF energy captation conditions such as for example by limiting the ratio between the exposed area of the conducting material on the wafer surface (antenna) and the coupling area with the dielectric layer, in order to limit the total amount of electric charge that may be accumulated, thus they are not easily adaptable to changing process conditions.

Another widely used approach, wherever it is difficult or unpracticable to assure safe conditions, consists of realizing dedicated protective diodes in parallel with the dielectric to be protected, that is, between the exposed conductor and the semiconductor substrate, in order to provide for a discharge path from the conductor material exposed to the plasma and the substrate and viceversa. This type of protection is perfectly effective when the junction (diode) is directly biased, but may be insufficient when the difference of potential caused by the charging of the exposed conductor the reverse biased protecting diodes, which, in the case of a gate dielectric, is inevitable, since the protecting diodes must be completely ininfluent under conditions of normal functioning of the finishing product.

In case of gates directly connected to input pins of the device, the protecting diodes will continue to function as a protection from accidental electrostatic discharges that may hit the pin while handling the device.

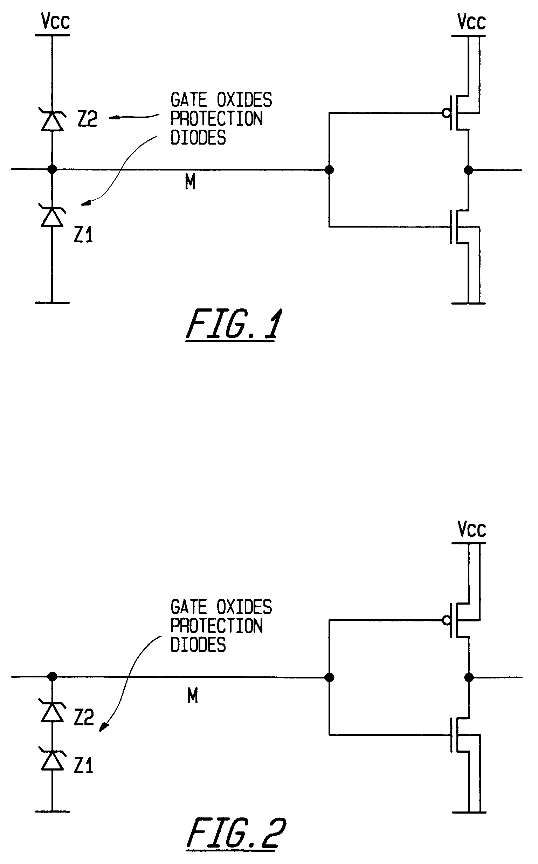

The protection diodes are typically N+/P or P+/N diodes or Zener and, Figures 1 and 2 show a typical arrangement of Zener diodes for protecting the gate dielectric of a CMOS inverter.

Of course, the Zener voltage must suit the designed supply voltage of the circuit and with the peculiar electrical properties of the structure to be protected. Two or more Zener diodes in series may be used to benefit of a greater flexibility in defining the range of allowed potentials.

In the two example shown, the metal line M represents a line of first level metal or a polysilicon gate line.

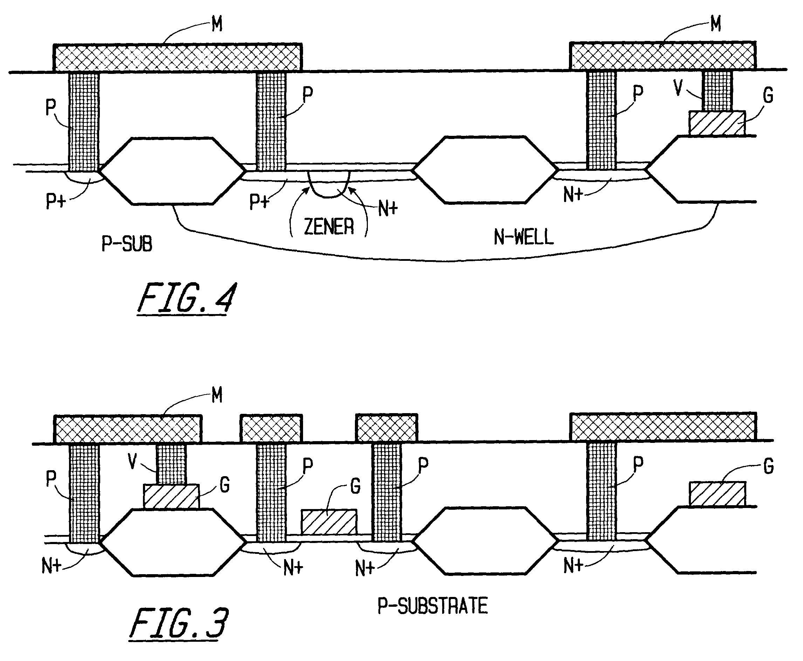

Fig. 3 shows a cross section of a semiconductor device during the fabrication process and more precisely at the stage when a first level metal is being patterned by masking, following the realization of the gate structures of the devices by patterning of a G layer of polysilicon.

During the plasma etching that patterns the metal layer M, the charging path of a gate dielectric passes through the interconnection (via) V between the polysilicon G and the metal layer M and the gate dielectric is protected by purposely forming an N+/P-substrate junction and by connecting it through a contact P to the conductor layer M. A similar protecting diode is shown also in the right side portion of the figure.

Fig. 4 shows another arrangement for protecting against an excessive charging of the gate polysilicon G with a Zener junction between the P+ and N+ regions and the contact towards substrate realized though the P contact and the P+ diffusion visible at the leftmost part of the cross section.

The constant technological advances of the processes of fabrication for scaling down integrated structures, makes ever more difficult to ensure a sufficient protection of dielectric layers as they become thinner and thinner and thus more delicate in terms of preservation of their optimal dielectric properties.

In these circumstances, the distribution and the structure of the protective junctions become more and more critical.

### OBJECT AND SUMMARY OF THE INVENTION

The object of the invention is to enhance the effectiveness of protective junctions (diodes and Zener diodes) for protecting dielectrics that may be negatively affected by discharge currents of voltages induced during plasma treatments of a wafer being processed.

It has now been found that by incrementing the reverse current through a Zener junction by illuminating with electromagnetic radiation in the visible or UV spectrum the wafer surface exposed to the plasma inside the chamber of the reactor, the effectiveness of the protection diodes realized on the wafer is outstandingly improved as it is reflected in a nonnegligible movement of the process yield.

A strong illumination of the wafer surface inside the plasma treatment reactor sensibly increases the availability of electron-hole pairs in the depleted region of the protection diodes functionally realized in connection with the structure to be protected during the plasma treatments contemplated by the fabrication process and thereby favor the discharge of those parts of conductor material on the wafer surface that are exposed to the plasma, limiting the level of induced voltage and therefore the stress on the dielectric electrically coupled to the charging part even when the sign of the potential induced by the plasma on the latter is such as to reversely bias the protection diodes.

To be fully effective, the illumination of the wafer surface should have a level of at least 1mW/cm², belonging to a region of the emission spectrum of a light source of energy greater than the forbidden gap, which in case of silicon, ranges between 1.1 eV. Of course, greater power densities may be employed, also in relation to the greater or lower transparency of staked layers in the active areas of the protection diodes on the underlying surface of the silicon substrate, taking into account possible shading effects.

The electromagnetic radiation source may be an incandescence lamp, a high pressure or a low pressure gas discharge lamp or a laser source. Preferably, high pressure or low pressure gas discharge lamps, having emission wave lengths in the visible and/or in the UV spectrum show a great efficiency in effectively stimulating the generation of electron-hole pairs. High pressure mercury gas lamps are particularly effective.

The illumination may be constant or alternatively the wafer surface may be sequentially scanned by a focused light beam.

Even, a continuous or pulsed laser source, allowing for a high intensity of a selected wavelength is adequate.

The radiation source may be installed either inside or outside the evacuable chamber of the plasma processing reactor. If placed outside, a transparent window must be provided in the chamber walls for illuminating the wafer or wafers to be treated.

The illumination should be maintained generally for the whole duration of the plasma treatment or at least during the steps of patterning of the interconnection metal layer.

### BRIEF DESCRIPTION OF THE DRAWINGS

**Figures 1**, **2**, **3** and **4**, as already mentioned, schematically show a protection diode layout on a wafer, according to known techniques;
**Figure 5** is a scheme of a parallel plate plasma etching system;
**Figure 6** shows a system modified according to the invention and enabling the illumination of the wafers subject to the etching process;
**Figure 7** is a scheme of an RF diode system for a reactive ion etching;
**Figure 8** shows a possible modification of the reactor of Fig. 7, according to the present invention.

### DESCRIPTION OF SEVERAL EMBODIMENTS OF THE INVENTION

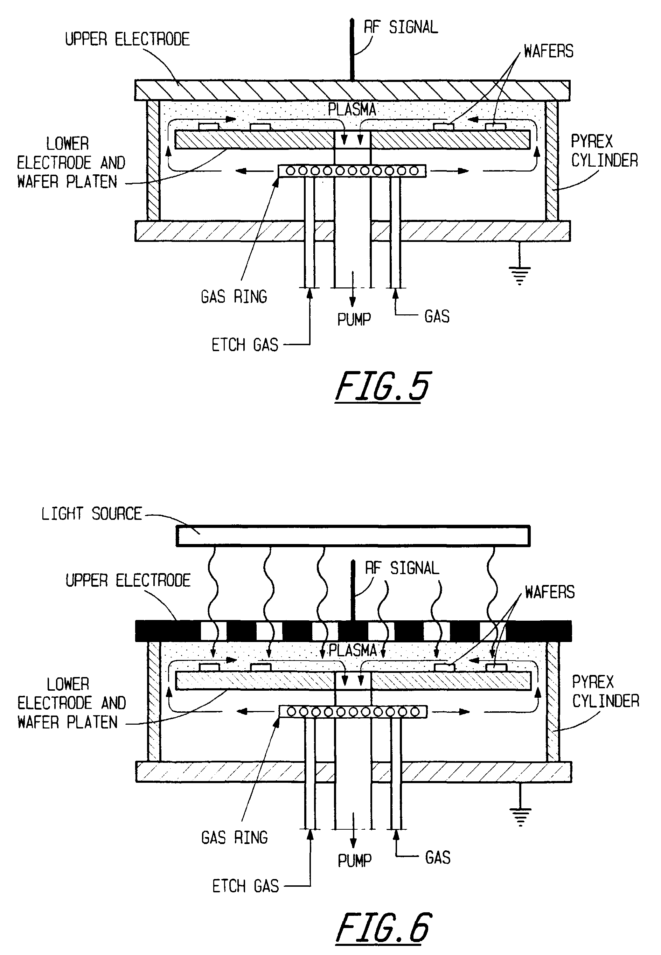

Fig. 5 depicts a parallel plate reactor of a plasma etching system.

Radio frequency energy (RF signal) is supplied through an upper electrode and the grounded wafers accommodating platen. The gas is injected in the previously evacuated chamber of the reactor through a dedicated ring distribution.

The plasma is for a large part confined in the space of separation between the upper electrode and the wafers platen. The confinement tends to increase the plasma potential.

Fig. 6 shows a suitably modified structure of the reactor of Fig. 5, according to the present invention, wherein the upper electrode, which constitute the top cover of the chamber is provided with a plurality of transparent windows through which, using one or more light sources, conveniently disposed outside of the reactor's chamber, illuminate the wafers supported on the grounded platen.

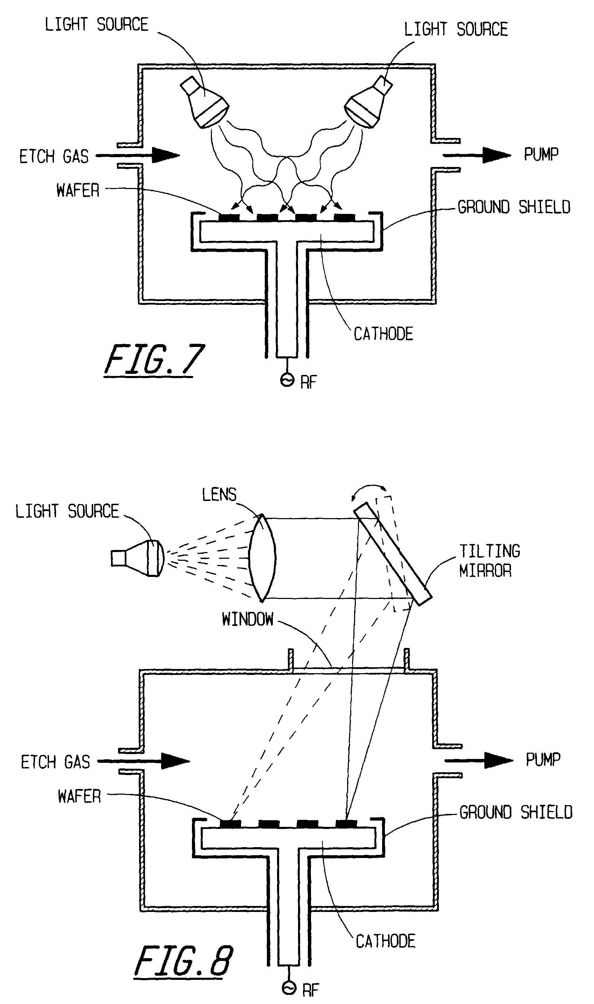

Another reactor that is commonly employed in the processes of fabrication of semiconductor devices is depicted in Fig. 7. The configuration is that of a reactor for carrying out a plasma etching with reactive ions (R.I.E.). In this case the radio frequency energy is supplied through an electrode (cathode) onto which are placed the wafers to be treated, while surrounding internal grounded parts of the reactor act as a counterelectrode (anode).

In this type of reactor, the cathode area, that is the area of the wafers platen, is much less that the anodic area represented by the confinement walls of the chamber and the plasma completely fills the reactor chamber.

The grounded screen opposed to the bottom face of the platen and surrounding the stem of the platen electrode prevent the occurrence of an etching action on these parts.

According to the present invention, appropriate light sources may be easily installed inside the chamber because of the generally ample internal volume available.

Of course, even in this case it remains possible to install the required light sources externally of the plasma treatment chamber by providing adequate transparent windows.

Fig. 8 schematically depicts a possible alternative embodiment wherein the wafers are illuminated by sequentially scanning their surfaces with a focused light beam implemented with means fined outside the treatment chamber including a motorized tilting-mirror.

## Claims

1. A fabrication process of a semiconductor device comprising the formation of diffused regions on a semiconductor substrate, deposition and successive patterning by masking and etching dielectric and/or the conductor layers staked on said substrate, wherein certain etchings and depositions are carried out in a plasma by placing the wafer on a platen-electrode biasable in respect to a counterelectrode of ionisable gases at a sub-atmospheric pressure, junctions being realized in said semiconductor substrate of the wafer and functionally connected to structural parts of electrically conductive material that during a step of the process are exposed to said plasma, for providing electrical discharge paths for electrical charges picked up by said exposed conductive parts to limit the level of induced voltages to values compatible with the preservation of the integrity of functional dielectric layers coupled to said exposed conductors parts and to said semiconductor substrate or to another conductive part, characterized in that during such plasma etching steps the wafer's surface is illuminated with electromagnetic radiation in the visible and/or in UV spectrum of energy and power density sufficient to enhance the reverse current through said protective junctions.

2. The process of claim 1, characterized in that said electromagnetic radiation is emitted by a source belonging to the group of incandescence lamps, high pressure gas discharge lamps, low pressure gas discharge lamps, halogen lamps and lasers.

3. An evacuable reactor for plasma treatments on a semiconductor wafer comprising a platen-electrode supporting the wafer and at least a counterelectrode for feeding RF energy to cause ionization of a gas injected in the evacuable reactor, characterized in that the reactor is equipped with an electromagnetic radiation source in the visible and/or UV spectrum illuminating the surface of said wafer during exposure to the plasma.

4. The reactor according to claim 3, characterized in that said electromagnetic radiation source is installed inside the evacuable chamber.

5. The reactor according to claim 3, characterized in that said electromagnetic radiation source is installed externally of said evacuable chamber which is equipped with at least a window transparent to said radiation.

6. The reactor according to claim 3, characterized in that said source belongs to a group consisting of incandescence lamps, high pressure gas discharge lamps, low pressure gas discharge lamps, halogen lamps and lasers.

7. The reactor according to one of the claims 3 to 6, characterized in that is equipped with a light beam deflection system of focused electromagnetic radiation emitted by said source for sequentially scanning the surface of said wafers.
